(19) Europäisches Patentamt

European Patent Office

Office européen des brevets

(11) **EP 0 650 066 B1**

(12) **EUROPEAN PATENT SPECIFICATION**

(45) Date of publication and mention
of the grant of the patent:
**17.05.2000 Bulletin 2000/20**

(51) Int. Cl.⁷: **G01R 15/24**

(21) Application number: **94116468.3**

(22) Date of filing: **19.10.1994**

(54) **Optical current transducer**

Optischer Stromwandler

Transducteur optique de courant

(84) Designated Contracting States:
**CH DE FR GB LI SE**

(30) Priority: **21.10.1993 JP 26283393**
**25.04.1994 JP 8612694**

(43) Date of publication of application:
**26.04.1995 Bulletin 1995/17**

(73) Proprietor:
**FUJI ELECTRIC CO. LTD.**
**Kawasaki 210 (JP)**

(72) Inventor:
**Koide, Hidenobu,**
**c/o Fuji Electric Co.,Ltd.**
**Kawasaki-ku, Kawasaki 210 (JP)**

(74) Representative:
**Hoffmann, Eckart, Dipl.-Ing.**
**Patentanwalt,**
**Bahnhofstrasse 103**
**82166 Gräfelfing (DE)**

(56) References cited:
**EP-A- 0 505 185          US-A- 4 962 990**

• **PATENT ABSTRACTS OF JAPAN vol. 13, no. 256 (P-884) 14 June 1989 & JP-A-01 053 169 (TOKYO ELECTRIC POWER) 1 March 1989**
• **PATENT ABSTRACTS OF JAPAN vol. 13, no. 250 (P-882) 12 June 1989 & JP-A-01 049 973 (TOKYO ELECTRIC POWER) 27 February 1989**
• **PATENT ABSTRACTS OF JAPAN vol. 14, no. 169 (P-1032) 30 March 1990 & JP-A-02 025 761 (TOSHIBA) 29 January 1990**
• **PATENT ABSTRACTS OF JAPAN vol. 16, no. 276 (P-1374) 19 June 1992 & JP-A-04 072 576 (FUJI ELECTRIC) 6 March 1992**
• **PATENT ABSTRACTS OF JAPAN vol. 14, no. 547 (P-1138) 5 December 1990 & JP-A-02 232 566 (TOKYO ELECTRIC POWER) 14 September 1990**
• **PATENT ABSTRACTS OF JAPAN vol. 12, no. 331 (P-755) 7 September 1988 & JP-A-63 094 167 (TOSHIBA) 25 April 1988**

**Description**

This invention relates to an optical current transducer which is used to measure relatively large currents flowing through a high-voltage conductor such as in a gas insulated power circuit interrupter, by utilizing the Faraday effect.

Current can be measured by utilizing the Faraday effect, i.e., a rotation phenomenon of the polarization plane of polarized light under the influence of a magnetic field established by the current to be measured. When polarized light is transmitted through a medium exhibiting the Faraday effect such as lead glass (hereinafter referred to as Faraday effect glass) and the medium is exposed to a magnetic field, the polarization plane is rotated by an angle of $\Theta = V \cdot H \cdot L$ (V:Verdet's constant, H:intensity of magnetic field in light travelling direction, L:glass length in light traveling direction). By detecting the angle $\Theta$ the magnetic-field intensity H can be measured by a well-known method. Where the magnetic field is caused by an electric current flowing in the neighborhood of the Faraday effect glass the value of the current can be calculated on the basis of the magnetic-field intensity H.

In many cases, plural conductors are disposed at an ordinary current measuring place, and thus there is a problem that a measurement is affected by magnetic field components which are caused by currents of conductors other than a conductor to be measured and this results in a measurement error. As an optical current transducer for solving the above problem by nullifying the effect of currents of the conductors other than the target conductor to be measured has been known an optical current transducer in which an optical path surrounding the conductor whose current is to be obtained, is set up and Faraday effect glass elements are disposed on the optical path.

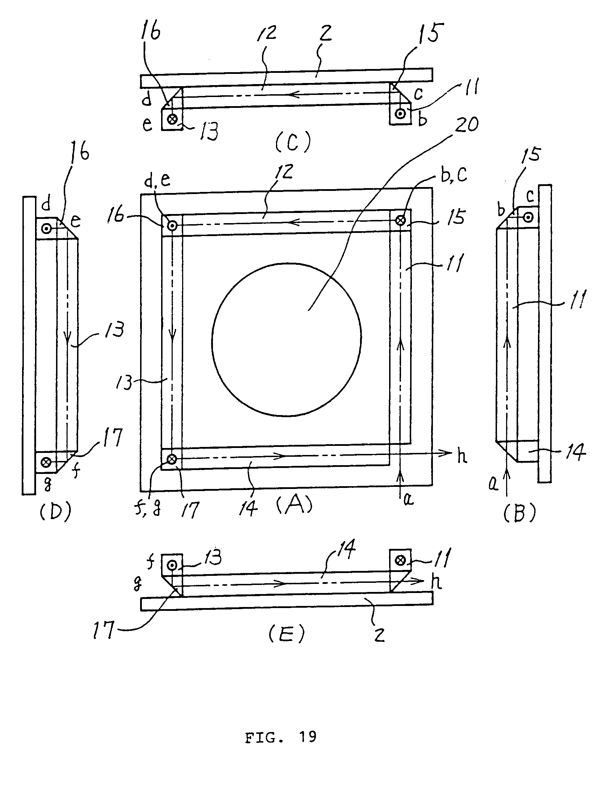

Fig. 19 is a projection view of a conventional optical current transducer. Fig. 19(A) is a plan view, and side views thereof are provided at the surrounding portions on the basis of trigonometry. That is, Figs. 19(B), 19(C),19(D) and 19(E) are side views of Fig. 19(A) which are viewed from the right side, upper side, left side and lower side, respectively. In this figure, rod-shaped Faraday effect glass elements 11, 12, 13 and 14 are disposed in a square form, and three optical-path changing pieces 15, 16 and 17 are provided at three of the four corners of the square. These elements are fixed to a substrate 2 with an adhesive agent, and also fixed to each other with an adhesive agent. A through hole 20 is provided at the center of the substrate 2, and a conductor (not shown) is penetrated through the through hole. A two-dotted chain line with an arrow represents an optical path. Input light a is transmitted through glass element 11, and then incident to optical-path changing piece 15. The light is totally reflected from a reflection plane at point b, which intersects the optical path at 45°. The light travelling direction is thus changed from a horizontal direction (parallel to the plane of the drawing) to a vertical direction (perpendicular to the drawing plane). The light is then totally reflected from another reflection plane at point c, so that the light travelling direction is changed from the vertical direction back to a horizontal direction toward the left side of the drawing and incident to glass element 12. Subsequently, in the same manner as described above, the light is transmitted along the optical path through optical-path changing piece 16, glass element 13, optical-path changing piece 17, and glass element 14 in this order, and finally emitted from the right side of the glass element 14 as an output light h. Since the light is transmitted while going around a conductor penetrating through the through hole 20 as described above, the polarization direction of the output light h is rotated relative to that of the input light a by an angle which is proportional to the current flowing through the conductor. The reflection points of the optical-path changing pieces are represented by d, e, f, g and symbols ⊙ and ⊗ representing a direction vertical to the drawing.

Since this invention is not related to the manner of generating the input light a and the way of processing the output light h (both may be the same as in the prior art) the description and illustration thereof are omitted. In the figures, the optical path is illustrated in a square, and thus all the glass elements 11 to 14 have the same length. This is why the through hole 20 is formed in a circular shape. If the conductor is designed to be a straight-angle conductor and the through hole 20 is designed in a slit shape, the optical path is preferably designed in a rectangular shape. In the following description, the shape of the optical path is limited to the square, however, as will be understood by those skilled in the art, it may be applied to a rectangular shape in the same way.

In the optical current transducer as described above, the glass elements 11, 12, 13 and 14 and the optical-path changing pieces 15, 16 and 17 are fixed to the substrate 2 with an adhesive agent. This is because, if the relative position between these elements deviates from a predetermined one, the optical path also deviates If this deviation is beyond a permissible range during a process in which the light is varied from the input light a to the output light h the normal output light h cannot be obtained, so that the optical current transducer cannot be normally operated. That is, with respect to the optical-path changing piece 15 for example, if the reflection point b or c deviates from the reflection surface, the subsequent optical path is disturbed. Accordingly, the firm fixation structure of the glass elements 11, 12, 13, 14 and the optical-path changing pieces 15, 16, 17 with an adhesive agent is adopted to prevent the positional deviation of these elements.

Epoxy resin or the like is generally used as adhesive agent. This adhesive agent is an organic material, and it has a coefficient of thermal expansion which is largely different from that of inorganic glass material used for the glass elements 11, 12, 13, 14 and the optical-path changing pieces 15, 16, 17. Accordingly, it has been found out that the following problems occur due to temperature variations:

1) Each of the optical-path changing pieces 15, 16, 17 is constructed by adhesively attaching two rectangular prisms with an adhesive agent, and a positional deviation occurs between the two rectangular prisms in accordance with temperature variations due to the difference in coefficient of thermal expansion between the optical-path changing pieces 15, 16, 17 and the adhesive agent, and the two reflection surfaces cannot be kept to be surely perpendicular to each other. Therefore, the polarization state of the light which is varied from a linearly polarized state to an elliptically polarized state through a first total reflection in the optical-path changing pieces 15, 16, 17 cannot be completely returned to the linearly polarized state through a second total reflection, so that the light is kept in the elliptical polarization state and thus an error occurs in an output signal.

2) The light is transmitted several times through adhesive layers which are located between the optical-path changing pieces 15, 16, 17 and the glass elements 11, 12, 13, 14 and between the respective two rectangular prisms constituting the optical-path changing pieces 15, 16, 17. The adhesive layers will show anisotropy through repetitive thermal stress which occurs in the layers due to temperature variations, and this causes a phase shift of two orthogonal components of light or light scattering, so that an error occurs in the output signal.

3) Due to the difference in coefficient of thermal expansion between the adhesive agent and the glass elements 11, 12, 13, 14, a phase shift of the two orthogonal components of the light occurs in the glass elements 11, 12, 13, 14 due to so-called photoelasticity when the temperature varies, so that an error occurs in the output signal.

As described above, these problems increase the error of the optical current transducer, and thus prevent the precision to be obtained which is required for the optical current transducer.

Document JP-A-63 094 167, in particular figures 4 and 5, shows an optical current transducer comprising the features of the preamble of claim 1.

An object of this invention is to solve these problems, and to provide an optical current transducer having a error within a predetermined permissible error range even with temperature variations.

This object is achieved with an optical current transducer as claimed in claim 1.

Preferred embodiments of the invention are subject-matter of the dependent claims.

In the construction of this invention, the four glass elements disposed so as to surround the through hole for the conductor and the three optical-path changing pieces are clamped between the two substrates, so that it is not required to fix the glass elements and the optical-path changing pieces to the substrates through an adhesive agent. Further, the optical-path changing pieces are respectively formed of one integral transparent element and the two reflection surfaces are formed by cutting the element, so that no adhesive agent is required to manufacture the optical-path changing pieces. In one embodiment of the invention, the optical-path changing pieces are also used as spacers for defining the interval between the two substrates, and the four glass elements are disposed in grooves which are formed in the substrates, and the dimension of the respective grooves of the substrates is set to be larger by a predetermined value than that of those portion of the glass elements which are to be inserted into the grooves, so that the glass elements are surely engaged in the grooves with enough clearance so that no stress is applied to the glass elements. Because of the gaps created by such clearance, the glass elements are slightly displaceable within the grooves. Since, however, at this time the emission light, when the light incident from one end surface of the glass element is emitted from the other end surface opposite to the incident surface, is varied only in its emission point, and it is not varied in its direction, the emission light can be kept in parallel to the incident light, and the optical path is not greatly deviated.

Further, the two substrates are provided with a proper number of bolt holes at predetermined positions, and the bolts of the bolt/nut sets for bolting are penetrated through the bolt holes. At this time, as described above, the optical-path changing pieces may serve as spacers, preventing the glass elements from being excessively firmly clamped between the substrates. In addition, the optical-path changing pieces are provided with bolt holes adapted to be registered with those of the substrates, and the bolts of the bolt/nut sets for bolting are penetrated through these bolt holes as well, so that no bending stress is applied to the substrates and fixing stress of the optical-path changing pieces is made uniform.

Further, in one embodiment of the invention a frame is provided on the peripheral portion of one of the two substrates so as to project to the other substrate, and the reflection surfaces of the optical-path changing pieces are constructed by the mirror surfaces of the two reflection portions fixed to the frame, and the frame serves as the spacer for defining the interval between the substrates, so that the optical-path changing pieces are not required to be formed of transparent material such as glass. The reflection portions to be fixed to the substrates may be formed integrally with the substrates, or the reflection portions may be manufactured separately from the substrates and fixed to the substrates by metal deposition or screwing. The reflection surfaces of the reflection portions may be coated with a metal coating to make mirror surfaces on the reflection surfaces when the reflection portions are formed of a non-metallic material, or the reflection surfaces are subjected to a mirror-polishing treatment when the reflection portions are formed of a metallic material.

When the optical-path changing pieces are respectively formed of one integral transparent element as described above, the optical-path changing pieces may be fixed through a fixing piece which is fixed to one of the substrates by bolting, so that the other substrate is not needed for the fixing of the optical-path changing pieces. Further, the frame is provided on the peripheral portion of one of the two substrates so as to project to the other substrate, so that the frame also serves as a spacer like the above case. The fixing piece is constructed by a fixing portion which is fixed to a flat surface portion by bolting, a flat surface portion on which the optical-path changing piece is mounted, and an L-shaped portion which is erectly secured to the flat surface portion so as to be closely attached to one corner portion of the optical-path changing piece, so that the displacement of the optical-path changing piece in three directions is restricted by the flat surface portion and the L-shaped portion.

Further, by inserting the elastic members between the grooves of the substrates and the glass elements, the displacement of the glass elements is restricted, and no thermal stress occurs in the glass elements because the support is soft. The elastic members may be inserted into wide areas on the surfaces of the glass elements which are confronted to the grooves, and formed of sponge or the like whose volume is easily variable, so that the thickness of the sponge is easily varied in accordance with the interval between the glass elements and the substrates, and thus the support is made soft. Further, the glass elements can be supported softly as described above by forming the elastic members of rubbers or springs and disposing these elastic members at plural local positions on the surfaces of the glass elements,

Embodiments according to this invention will be described hereunder with reference to the drawing, which show specific embodiments only.

Fig. 1     are projection views showing the optical current transducer of a first embodiment of this invention, wherein Fig. 1(A) is a plan view, Fig. 1(B) is a side view of Fig. 1(A) viewed from the right side, Fig. 1(C) is a side view of Fig. 1(A) viewed from the upper side, Fig. 1(D) is a side view of Fig. 1(A) viewed from the left side, and Fig. 1(E) is a side view of Fig. 1(A) viewed from the lower side.

Fig. 2     is a cross-sectional view taken along line A-A of Fig. 1.

Fig. 3     is an enlarged partial projection view, where Fig. 3(A) is a plan view and Fig. 3(B) is a side view.

Fig. 4     is an enlarged partial projection view showing an effect on an optical path when the glass elements of Fig. 1 are deviated, where Fig. 4(A) is a plan view, and Fig. 4(B) and Fig. 4(C) are side views.

Fig. 5     is a cross-sectional view taken along line A-A of Fig. 1(A) showing a second embodiment of this invention.

Fig. 6     is a cross-sectional view of view taken along line A-A of Fig. 1(A) showing a third embodiment according to this invention.

Fig. 7     is a plan view of the optical current transducer of a fourth embodiment of this invention.

Fig. 8     is a side view of Fig. 7 as viewed along an arrow A.

Fig. 9     is a side view of Fig. 7 as viewed along an arrow B.

Fig. 10     is a cross-sectional view taken along line C-C of Fig. 7.

Fig. 11     is a side view of Fig. 7 as viewed along an arrow D.

Fig. 12     are enlarged partial projection views of the optical current transducer a fourth embodiment of this invention, where Fig. 12(A) is a plan view, Fig. 12(B) is a side view of Fig. 12(A) which is viewed from the left side, and Fig. 12(C) is a side view of Fig. 12(A) which is viewed from the lower side.

Fig. 13     are enlarged partial projection views of the optical current transducer of a fifth embodiment of this invention, where Fig. 13(A) is a plan view, Fig. 13(B) is a side view of Fig. 13(A) which is viewed from the left side, and Fig. 13(C) is a side view of Fig. 13(A) which is viewed from the lower side.

Fig. 14     are enlarged partial views of the optical current transducer of a sixth embodiment of this invention, where Fig. 14(A) is a plan view, Fig. 14(B) is a side view of Fig. 14(A) which is viewed from the left side, and Fig. 14(C) is a side view of Fig. 14(A) which is viewed from the lower side.

Fig. 15      are enlarged partial views of the optical current transducer of a seventh embodiment of this invention, where Fig. 15(A) is a plan view, Fig. 15(B) is a side view of Fig. 15(A) which is viewed from the left side, and Fig. 15(C) is a side view of Fig. 15(A) which is viewed from the lower side.

Fig. 16      is a plan view of the optical current transducer of an eighth embodiment of this invention.

Fig. 17      is a side view of Fig. 16 as viewed along an arrow A.

Fig. 18      are triangular diagrams of only the optical-path changing piece and the fixing piece of Fig. 17, where Fig. 18(A) is a plan view, Fig. 18(B) is a side view of Fig. 18(B) which is viewed from the upper side and Fig. 18(C) is a side view of Fig. 18(A) which is viewed from the right side.

Fig. 19      are projection views of a conventional optical current transducer, where Fig. 19(A) is a plan view, Fig. 19(B), Fig. 19(C), Fig. 19(D) and Fig. 19(E) are side views of Fig. 19(A) which are viewed from the right side, upper side, left side and lower side.

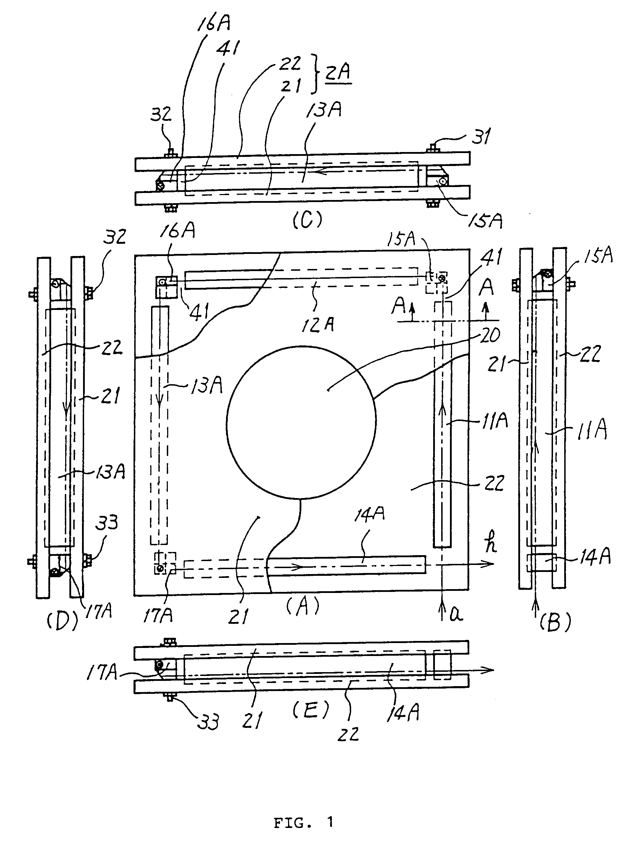

Fig. 1 is a projection view of an optical current transducer of an embodiment according to this invention, where Fig. 1(A) is a plan view, and side views are disposed around the plan view on the basis of the trigonometry. That is, Fig. 1(B) is a side view which is viewed from the right side of Fig. 1(A), Fig. 1(C) is a side view which is viewed from the upper side of Fig. 1(A), Fig. 1(D) is a side view which is viewed from the left side of Fig. 1(A), and Fig. 1(E) is a side view which is viewed form the lower side of Fig. 1(A). Fig. 1 is similar to Fig. 19, and the same elements are represented by the same reference numerals. Similar members are denoted by the reference numeral affixed with affix letter A, and the detailed description thereof on the common construction and function is omitted.

In Fig. 1, Faraday effect glass elements 11A, 12A, 13A, 14A and optical-path changing pieces 15A, 16A, 17A are sandwiched between two substrates 21, 22, and fixed to the substrates by clamping them with bolt/nut sets 31, 32, 33. However, as described later, the glass elements 11A, 12A, 13A, 14A are fixed so as to be movable or fixed softly through elastic members. Gaps 41 are formed between the optical-path changing pieces 15A, 16A, 17A and the glass elements, and the optical-path changing pieces 15A, 16A, 17A are respectively formed of one element. That is, the fixing of the glass elements 11A, 12A, 13A, 14A and the optical-path changing pieces 15A, 16A, 17A is performed with no adhesive agent. Accordingly, the problems as described above which would occur if the adhesive agent is used are solved. However, as described later, the positioning of the optical-path changing pieces 15A, 16A, 17A may be performed with a slight amount of adhesive agent for temporary fastening.

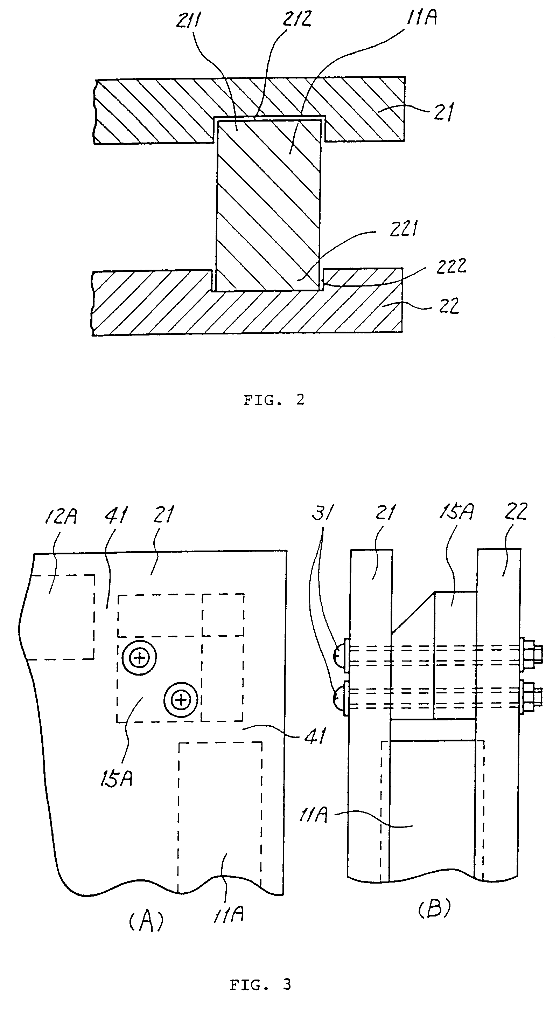

Fig. 2 is a cross-sectional view along a line A-A of Fig. 1(A). In this figure, the substrates 21, 22 are provided with grooves 211, 221, and both ends of the glass element 11A are inserted into the grooves. There are gaps 212, 222 between the substrates 21, 22 and the glass element 11A, and the glass element 11A is displaceable in the range of the gap interval. As described later, a slight displacement of the glass element 11A provides no obstruction to the function of the optical current transducer. With the structure that the glass element 11A is not firmly fixed, an internal stress can be prevented from occurring in the glass element 11A even when the temperature varies.

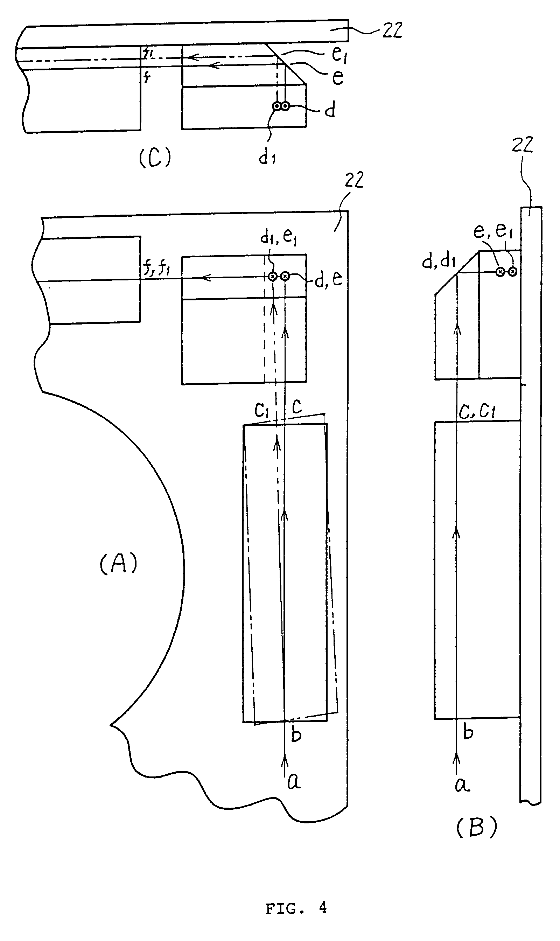

Fig. 3 is an enlarged partial projection view of a mount portion of the optical-path changing piece 15A, where Fig. 3(A) is a plan view and corresponds to Fig. 1(A) while Fig. 3(B) is a side view and corresponds to Fig. 1(B). In this figure, two bolts of bolt/nut sets 31 are penetrated through two bolt holes which are provided in the substrates 21, 22 and the optical-path changing piece 15A, and the bolts are fastened with nuts. A portion of the optical-path changing piece 15A at which the bolt/nut sets are provided is provided outside the optical path, so that it does not affect the optical path. The interval between the substrates 21 and 22 when these substrates are fixed through the bolt/nut sets 31 is determined by the thickness of the optical-path changing piece 15A. The dimension of the respective elements are beforehand determined so that the gap intervals 212, 222 shown in Fig. 2 are formed between the glass element 11A and the substrates 21, 22 when the substrates 21, 22 are fixed to each other at the above interval. Of course, it is better that the gaps 212, 222 are small, and thus the dimension of the respective elements is determined in consideration of the manufacturing errors of the respective elements.

In Fig. 3, two bolt/nut sets 31 are provided to fix the optical-path changing piece 15A, however, one bolt/nut set may be used as shown in Fig. 1.

Fig. 4 are three enlarged partial projection views for showing an effect on the optical path when a glass element is positionally deviated from a normal position, where Fig. 4(A) is a plan view corresponding to Fig. 1(A), Fig. 4(B) is a side view corresponding to Fig. 1(B), and Fig. 4(C) is a side view corresponding to Fig. 1(C). In all the figures, illustration of the substrate 21 is omitted and the glass element and the optical-path changing piece in Fig. 4(A) is illustrated as being exposed.

A solid line represents the glass element 11A located at a normal position, and a two-dotted chain line represents the glass element 11A at a position deviated from the normal position. In the figure, in the displaced position, the glass element is counterclockwisely rotated with respect to the normal position. A solid line having an arrow represents an optical path when the glass element 11A is located at the normal position indicated by the solid line, and a two-dotted chain line having an arrow represents an optical path when the glass element 11A is located at the position indicated by the two-dotted chain line. The incident point and the emission point of the glass element 11A, etc. and the reflection point in the optical-path changing piece 15 in the optical path are represented by alphabetic lowercase letters in alphabetic order. No affix letter represents the glass element at the normal position, and affix letter "1" represents the glass element at the deviated position. In the following description, the glass element 11A at the normal position is referred to as a normal glass element, and the glass element 11A at the deviated position is referred to as a deviated glass element.

The incident point b of an incident light a to the glass element 11A is substantially the same position between the normal glass element and the deviated glass element. The direction perpendicular to the surface of the normal glass element at the incident point b is coincident with the travel direction of the incident light a, and thus no refraction occurs. Therefore, the incident light a and the optical path in the normal glass element are on the same straight line. On the other hand, with the deviated glass element, the light impinges at an angle corresponding to the rotation angle, and thus refraction occurs. Therefore, the optical path as indicated by the two-dotted chain line is deviated to the left from the normal optical path as shown in the figure. Therefore, the emission point c1 of the deviated glass element is slightly deviated to the left side from the emission point c of the normal glass element. The light is refracted again at the emission point c1 to compensate the bend of the optical path due to the refraction at the point b, and thus the emitted light from the emission point c1 is in parallel to the emission light from the emission point c. As described above, even when the glass element 11A (or any of the other glass elements) is rotationally displaced, the emission light thereof is in parallel to the incident light. This is why the slight displacement of the glass element does not affect the characteristics of the optical current transducer, and the soft fixing can be performed. Further, variation of the optical path for the normal glass element and the deviated glass element will be described in detail taking glass element 11A as an example.

Since the emission light from the glass element 11A is parallel to the direction perpendicular to the incident surface of the optical-path changing piece 15A, the emission light is incident with no refraction for both of the normal glass element and the deviated glass element, reflected at the reflection point d or d1 and the reflection point e or e1, and then emitted from the surface at the left side of the figure of the optical-path changing piece 15A. The reflection points d and d1 and e and e1 are different in position from one another, however, the respective optical paths are incident to the glass element 12A while kept in parallel to each other. Subsequently, likewise, even if the optical path is deviated due to a rotational displacement of the position of the next glass element, the optical paths are kept in parallel to each other at the outside of the glass element. Accordingly, the normal output light h as the optical current transducer output can be obtained unless the optical path is deviated to an extent as to no longer impinge on the two reflection surfaces of the respective optical-path changing pieces. Of course, it is indispensable that a photodetector (not shown) can surely photodetect the output light h even if it is deviated from the normal position.

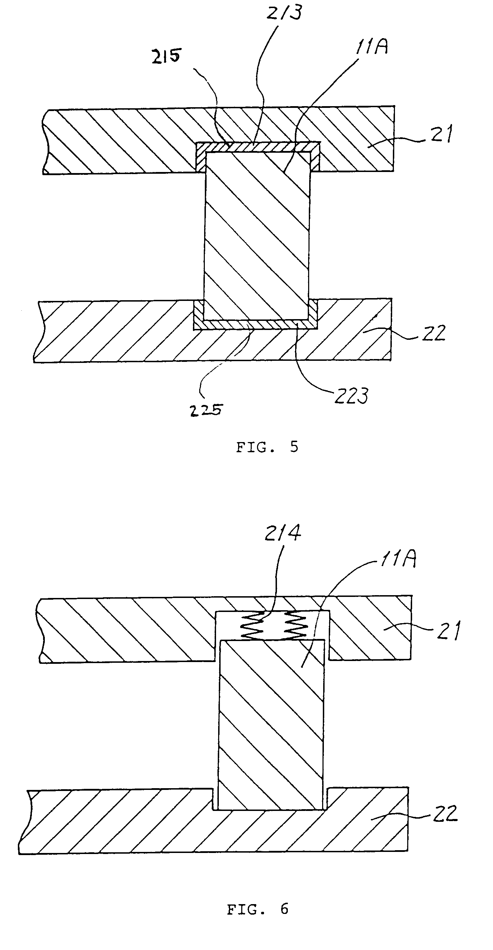

Fig. 5 is an A-A cross-sectional view of Fig. 1(A), which shows another embodiment of this invention. The different point of this figure from Fig. 2 resides in that sponges 213, 223 serving as elastic members are filled into the gaps 212, 222 between the substrates 21, 22 and the glass element 11A (note that here glass element 11A is merely taken as an example for all of the four glass elements). As described above, the characteristics of the optical current transducer is not effected by the positional deviation of the glass elements 11A to 14A. However, in a case where the glass elements 11A to 14A are designed to be freely movable with no restriction, within the boundaries of the groove, as shown in Fig. 2, the glass elements 11A to 14A and the substrates 21, 22 may collide with each other and any one of these elements may be damaged due to movement or vibration of the optical current transducer although this phenomenon is dependent on the size of the grooves 211, 221. Accordingly, as shown in Fig. 5, the sponges 213, 223 are merely inserted into the optical current transducer to prevent the displacement of the glass elements 11A to 14A. However, even when difference in dimension occurs between the glass elements 11A to 14A and the substrates 21, 22 due to temperature variation, the sponges 213, 223 can easily absorb the difference in dimension, so that no internal stress occurs in the glass elements 11A to 14A. Further, the restriction of the displacement of the glass elements 11A to 14A by employing the sponges 213, 223 reduces the variation of the optical path, and thus there is an advantage that the optical current transducer is more stabilized.

When the elastic members are filled into the gaps 212, 222 as shown in the figure, the elastic members are preferably largely variable in volume, such as sponges. This is because overstrain is liable to occur with a member whose volume is only slightly variable, such as a rubber plate. In the figure, the sponges 213, 223 are inserted into both gaps between the substrates 21, 22 and the upper and lower sides of the glass element 11A, however, a sponge may be inserted into only one gap. Further, the sponges may be inserted over the overall length in the direction perpendicular to the drawing surface, or may be partially inserted. At any rate, they may be inserted in such an extent that the glass element 11A is not easily moved.

Fig. 6 is an A-A cross-sectional view of Fig. 1(A), which shows another embodiment of this invention. In this figure, two springs 214 are used as the elastic members. The springs 214 serve to restrict the displacement of the glass element 11A in an up-and-down direction in the figure, and also to restrict the displacement thereof in a right-and-left direction by friction with the substrate 22. Since it is impossible to design the springs 214 to be thinner than the sponges 213, 223, the gap is made larger to accommodate the springs as shown in the figure. However, this design is not essential. When the locally pressing structure as described above is adopted, rubber may be used in place of the springs 214.

As mentioned before, in Fig. 5, the sponges 213, 223 are provided to both of the upper and lower grooves 215, 225, however, may be provided to only one groove like Fig. 6. If the elastic member such as the sponge 213 or spring 214 is provided to only one groove, the other side of the glass element 11A is directly contacted with the bottom of the groove, and thus there is an advantage that the position of the glass element 11A in the upper and lower direction in Fig. 5 is more stabilized.

At any rate, any other constructions than the above constructions may be adopted without departing from the scope of this invention as long as the glass element 11A is mounted to the substrates 21, 22 in a soft, resilient state. The mount construction of the other glass elements 12A to 14A is identical to that of the glass element 11A.

The procedure in which the glass elements 11A, 12A, 13A, 14A and the optical-path changing pieces 15A, 16A, 17A are disposed as shown in Fig. 1 and these elements are fixed using the bolt/nut sets 31, 32, 33 to fabricate an optical current transducer is mainly performed as follows.

(1) The substrate 22 is disposed horizontally so that the groove 221 is placed face-up, and the optical-path changing pieces 15A, 16A, 17A are disposed at temporary positions. In this state, input light a is input and the output light h is obtained.
(2) The optical-path changing pieces 15A, 16A, 17A are positionally adjusted so that the output light h is at a normal position, and the respective optical-path changing pieces are temporarily fixed with a slight amount of adhesive agent after the positional adjustment. Since only a slight amount of adhesive agent is used, there occurs no problem due to the difference in coefficients of thermal expansion as described. In other words, the temporary fixing is performed with such an amount of adhesive agent that no problem occurs.
(3) When the elastic members such as the sponges 213, 223 or springs 214 shown in Fig. 5 or 6 are inserted, the glass elements 11A, 12A, 13A, 14A are inserted into the grooves after the elastic members have been inserted.
(4) The substrate 21 is secured. At this time, the elastic members are secured if necessary.
(5) The bolts of the bolt/nut sets 31, 32, 33 are penetrated through the bolt holes of the substrates 21, 22 and the optical-path changing pieces 15A, 16A, 17A and fastened by nuts.

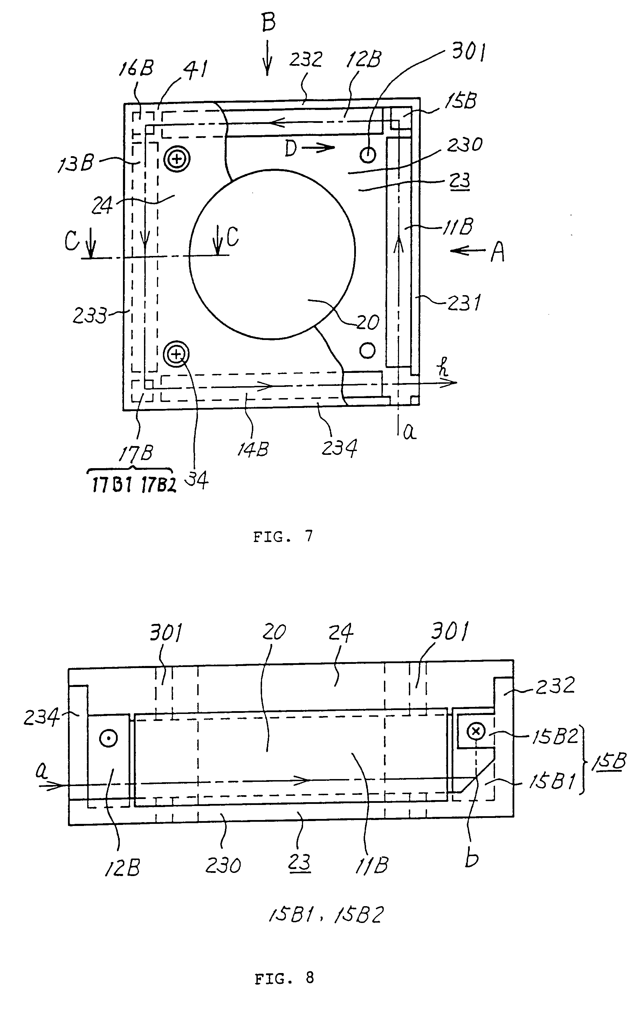

Fig. 7 is a plan view of the optical current transducer of a fourth embodiment according to this invention. In this figure, four Faraday effect glass elements 11B, 12B, 13B and 14B are sandwiched between substrates 23, 24 and disposed at respective sides of a square. Light emitted from an external light source is incident from the right lower side to the upper side, and transmitted through the respective glass elements. The optical path of the light is vertically and horizontally bent by the optical-path changing pieces 15B, 16B, 17B at the corner portions of the square, whereby the optical path or loop starting in a first direction at the lower right corner and ending in a second direction, substantially perpendicular to the first direction, at the same corner, is finally formed. The optical path is represented by a two-dotted chain having an arrow. The subsequent drawings (Figs. 8, 9, 11 to 18) are similar to Figs. 19 and 1. As described later, the construction of the optical-path changing pieces 15B, 16B, 17B is different from that of the optical-path changing pieces 15A, 16A, 17A, and also the construction of the substrates 23, 24 is different from that of the substrates 21, 22. As in the case of the substrates 21, 22 shown in Fig. 1 the through hole 20 is formed at the center of the substrates 23, 24.

In the figure, the substrate 23 is located at the lower side and the substrate 24 is located at the upper side. In the drawing, an upper right half portion of the substrate 24 is cut out to wholly or partially expose the glass elements 11B, 12B, 13B, 14B and the optical-path changing piece 15B, as indicated by a solid line. The substrates 23, 24 sandwiching these elements are provided with bolt holes 301, and bolts of bolt/nut sets 34 are penetrated through the bolt holes and fastened by nuts, whereby the whole device is mechanically unified into one body.

The substrate 23 is provided with frames 231, 232, 233, 234 projecting to the substrate 24 side on the periphery of the flat portion 230 thereof. These frames are formed integrally with the substrate 23, and cut out at a lower right side in Fig. 7 from which the light is incident. In place of the cut-out, a through hole having a diameter required for light transmission may be formed.

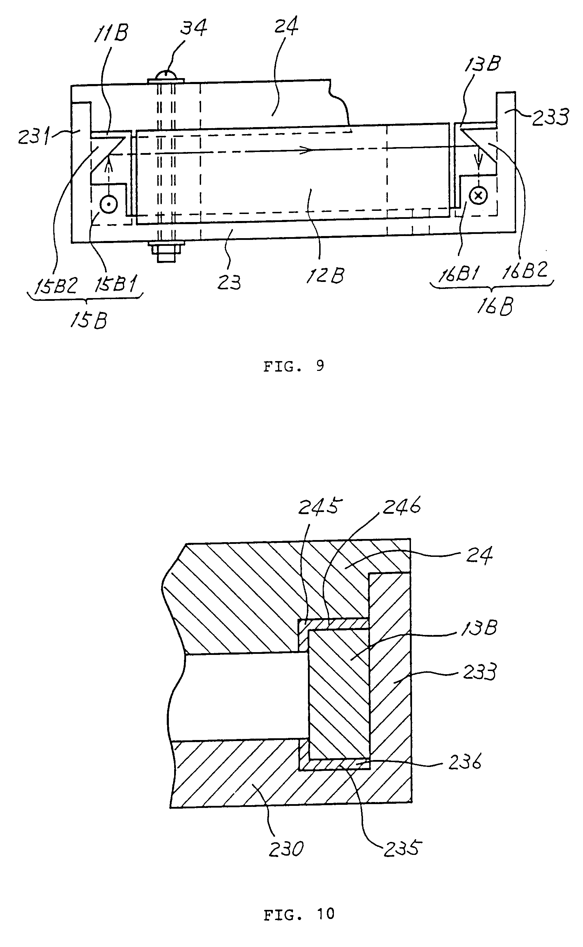

Fig. 8 is a side view which is viewed along an arrow A, with the frame 231 of Fig. 7 being omitted, and Fig. 9 is a side view which is viewed along an arrow B with the frame 232 of Fig. 7 being omitted. As is apparent from Figs. 8 and 9, the substrate 24 at the upper side in the figure is contacted with the upper portions of the frames 231, 232, 233, 234 and thereby its position is determined. The frames 231, 232, 233, 234 serve as spacers for defining the interval between the flat portion 230 of the substrate 23 and the substrate 24.

As is apparent from Figs. 8, 9 and 11, each of the optical-path changing pieces 15B, 16B, 17B disposed at the four corners of the square comprises two prism-like members projecting inwardly from the frames 231, 232, 233, 234, and these prism-like members are integrally formed of the same material as the frames 231, 232, 233, 234. As shown in Fig. 8, the optical-path changing piece 15B comprises reflection portions 15B1 and 15B2, and the reflection portion 15B1 has the shape of an isosceles right triangle in section, the slant surface thereof in the figure serving as the reflection surface. The reflection portion 15B2 has the same shape as the reflection portion 15B1, however, the slant reflection surface is located at the back side of the drawing and thus it is merely illustrated in a square form.

The input light a is transmitted through the glass element 11B, reflected at the point b on the reflection surface of the reflection portion 15B1 to vary its travelling direction from the leftward direction to the upward direction, reflected at the point c on the reflection surface of the reflection portion 15B2 to vary its travelling direction to a backward direction of the drawing which is perpendicular to the drawing surface as indicated by a direction symbol ⊗ in the figure. Accordingly, the light incident to the reflection portion 15B1 is varied in its direction after reflected from the reflection portion 15B2. That is, the optical-path changing piece 15B constructed by the reflection portions 15B1 and 15B2 has the same action as the optical-path changing pieces 15A, 16A, 17A shown in Fig. 1 for the light reflection, and the optical-path changing pieces 16B, 17B have the same action.

Figs. 7 to 11 are based on the assumption that the optical-path changing pieces are made from metal, and the reflection surfaces of the reflection portions 15B1, 15B2, 16B1, 16B2, 17B1, 17B2, which intersect the respective optical paths at 45°, are mirror-polished. Hereupon, reflection portions 17B1 and 17B2 have a construction similar to the pair of 15B1 and 15B2 or the pair of 16B1 and 16B2.

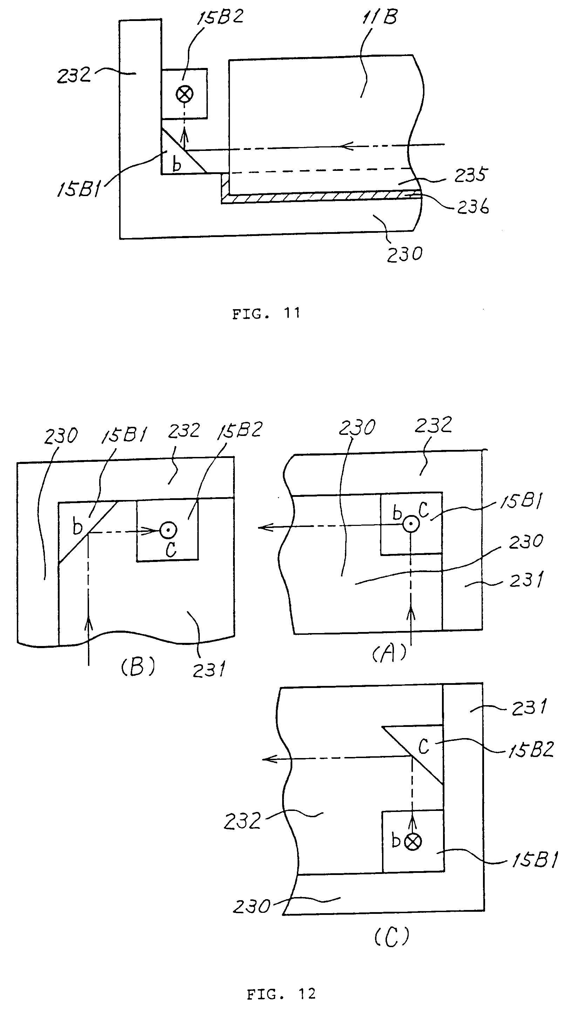

Fig. 10 is a C-C cross-sectional view of Fig. 7, and Fig. 11 is a side view which is viewed from an arrow D of Fig.7. In these figures, the glass element 13B is inserted into the groove 235 provided on the flat surface portion 230 of the substrate 23 and the groove 245 provided in the substrate 24, and sponges 236 and 246 serving as elastic members are sandwiched therebetween. The width and depth of the grooves 235, 245 are set in association with the dimension of the glass element 13B so that the sponges 236, 246 keep a predetermined thickness. The same effect as obtained using the sponges 213, 223 of Fig. 5 is obtained by softly supporting the glass element 13B through the sponges 236, 246. Alternatively, the springs may be used in place of the sponges as shown in Fig. 6, or the glass element may be inserted into the grooves without filling the gaps 212, 222 with elastic material or the elastic members such as the sponge or springs shown in Fig. 2.

Fig. 12 is an enlarged partial projection view for showing the construction and function of the optical-path changing piece 15B, where Fig. 12(A) is a plan view corresponding to the upper right portion of Fig. 7, Fig. 12(B) is a side view of Fig. 12(A) which is viewed from the left side, and Fig. 12(C) is a side view of Fig. 12(A) which is viewed from the lower side. Fig. 12(B) is also a view obtained by clockwisely rotating Fig. 11 by 90°. Illustration of the glass element 11B, etc. is omitted. The function of the optical-path changing piece 15B will be described in more detail with reference to these figures.

The light incident from the lower side in Figs. 12(A) and 12(B) is first reflected at the point b on the reflection surface of the reflection portion 15B1. The reflection surface intersects the optical path at an angle of 45°, so that the light travel direction is varied to the reflection portion 15B2 by 90°. The reflection surface of the reflection portion 15B2 also intersects the light travel direction at 45°, so that the light travel direction is again varied by 90° at the point c. Therefore, as shown in Fig. 12(A), the light incident from the lower side is finally directed to the optical-path changing piece 16B. At this time, the distance between the optical path and the flat surface portion 230 of the substrate 23 is varied from the position b nearer to the flat surface portion 230 to the position c farther from the flat surface portion 230. As is apparent from the figures as described above, the elements are set so that the optical path is not deviated from the glass elements 11B, 12B, 13B, 14B irrespective of the variation of the distance between the optical path and the flat surface portion 230.

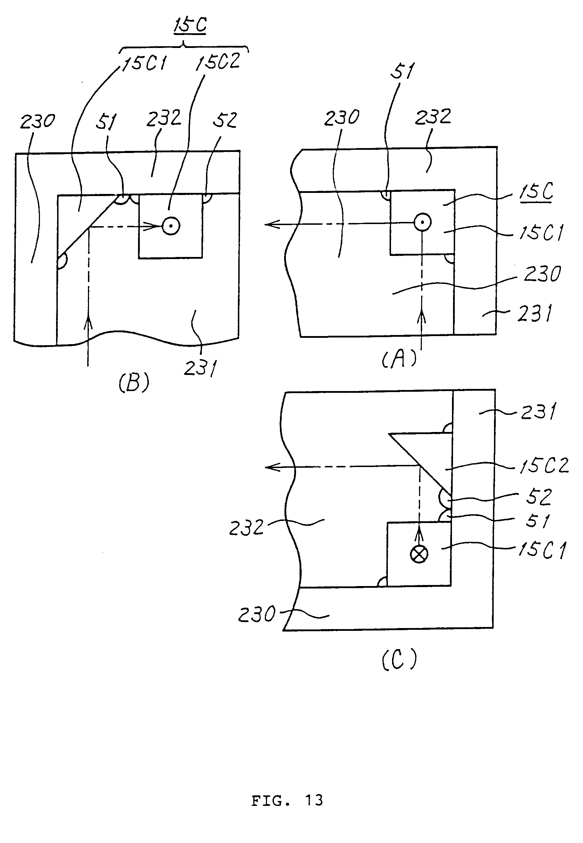

Fig. 13 is an enlarged partial projection view of a fifth embodiment according to this invention. The same elements as in Fig. 12 are represented by the same reference numerals, and will not be described again. Figs. 13 (A) to 13(C) are identical to Figs. 12(A) to 12(C), respectively, except for the construction of the optical-path changing piece 15B. In this embodiment, the substrate 23 and the optical-path changing piece 15C are formed of metal, and the reflection portion 15C1 and the reflection portion 15C2 constituting the optical-path changing piece 15C is manufactured separately from the substrate 23. These reflection portions are adhesively attached to the flat surface portion 230, frames 231, 232 by metal deposition such as welding. The elements shown in Fig. 12 are not necessarily identical in material to the corresponding elements in Fig. 13. This difference is not illustratively discriminated by affixing symbols, but only the optical-path changing pieces are discriminated by affixing different alphabetic affix letters. The same is adopted in the following description.

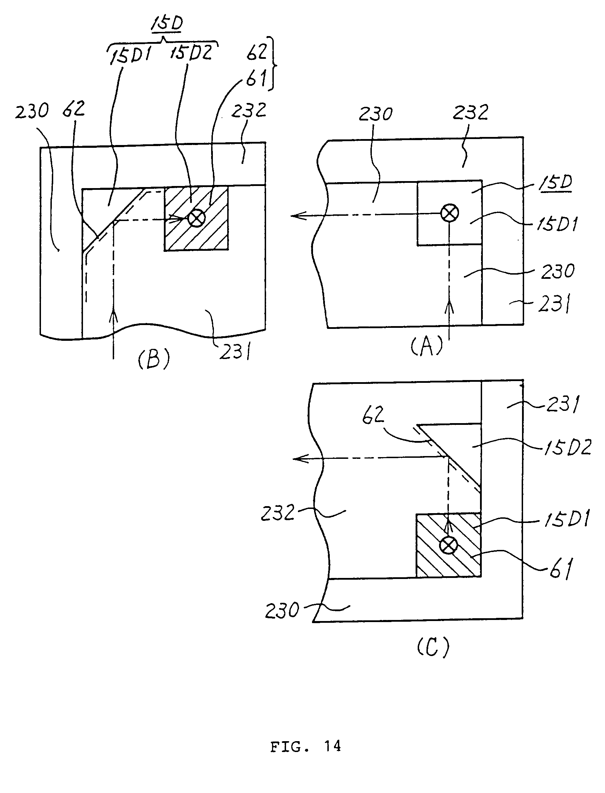

Fig. 14 is an enlarged partial projection view of a sixth embodiment of this invention. The same elements as in Fig. 13 are represented by the same reference numerals and are not described. Figs. 14(A) to 14(C) correspond to Figs. 13(A) to 13(C), respectively, except for the construction of the optical-path changing piece 15D. The reflection portions 15D1, 15D2 of this embodiment are formed integrally with the frames 231, 232, and formed of non-metal material such as ceramic material or the like. Accordingly, metal is deposited on the reflection surfaces to form metal films 61, 62 as indicated by chain lines and oblique lines and thus form mirror surfaces. When these elements are formed of metal, but its reflectivity is lower, a metal film having high reflectivity such as aluminum, silver or the like may be provided.

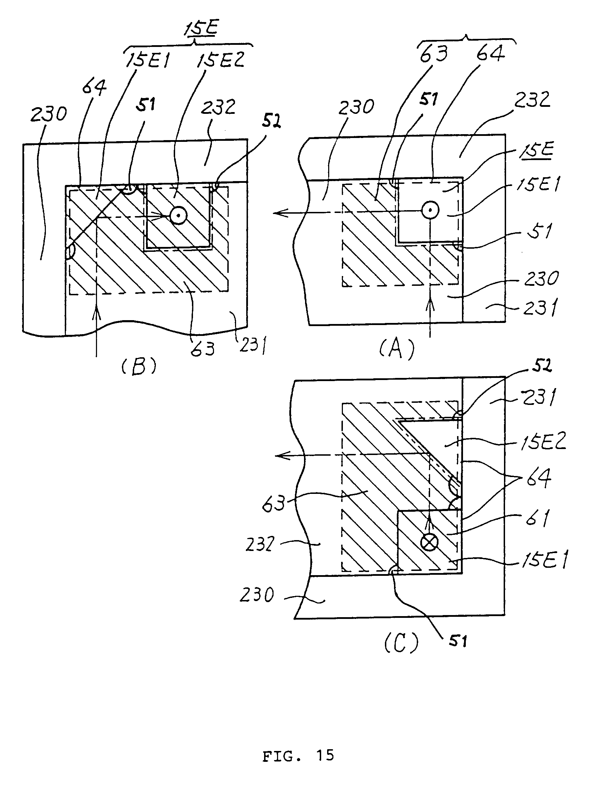

Fig. 15 is an enlarged partial projection view of a seventh embodiment according to this invention. The same elements as in Fig. 14 are represented by the same reference numerals, and are not described. Figs. 15(A) to 15(C) correspond to Figs. 14(A) to 14(C), respectively, except for the construction of the optical-path changing piece 15E. The flat surface portion 230 of the substrate 23, the frames 231, 232 and the reflection portions 15E1, 15E2 are formed of non-metal material such as ceramic material, and the reflection portions 15E1, 15E2 are manufactured separately from the flat surface portion 230 and the frames 231, 232, and then these elements are adhesively fixed to one another. Since these elements are formed of non-metallic material, fixing of the optical-path changing pieces to the substrate cannot be made directly by a metal deposition technique like soldering. Therefore, like the reflection surfaces, deposition of metal is performed for these elements, containing a fixing portion, to form metal films 63, 64, and the metal deposition using a soldering is performed through these metal films to form deposit portions 51, 52.

As described above, various methods for forming the reflection surfaces of the reflection portions constituting the optical-path changing piece and adhesively attaching the substrate and the optical-path changing piece to each other may be used in accordance with the materials of the substrate and the optical-path changing pieces to be fixed to the substrate. The materials of the substrate and the optical-path changing pieces are selected in consideration of various points such as workability, relationship in coefficient of thermal expansion with the glass elements, etc., and the method of forming the reflection surfaces and the adhesion method are selected in accordance with a combination of selected materials. Even when the substrate and the optical-path changing piece are formed of the same material, it is not necessarily reasonable that these elements are formed integrally with each other. Since the reflection portion of the optical-path changing piece may be separately manufactured and then adhesively fixed to the substrate, in this case the reflection surface forming method and the adhesion method are also selected in accordance with the material of these element (metal or non-metal).

Since no organic adhesive agent such as epoxy resin is used not only when the substrate and the optical-path changing piece are formed integrally with each other, but also when the optical-path changing piece is adhesively fixed to the substrate, this invention is not affected by photoelasticity due to different coefficients of thermal expansion, and there is no factor which induces deterioration of material with time lapse.

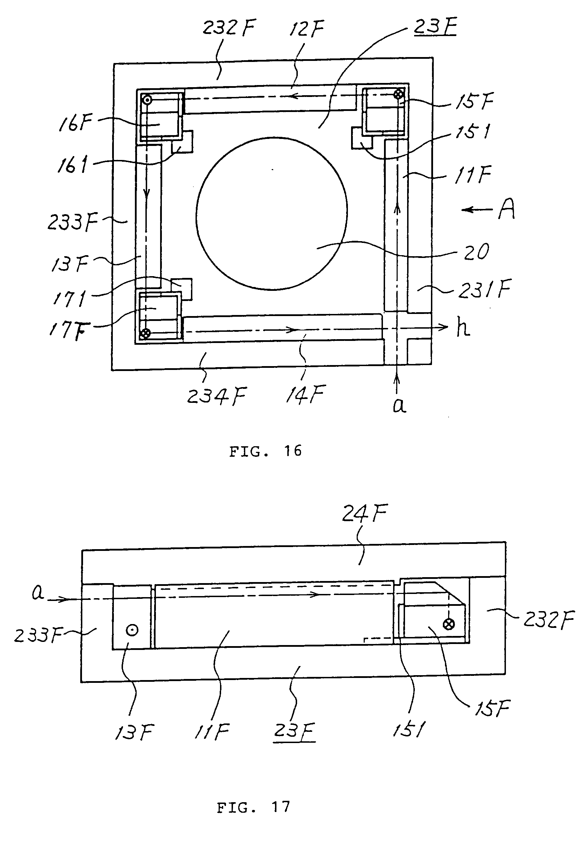

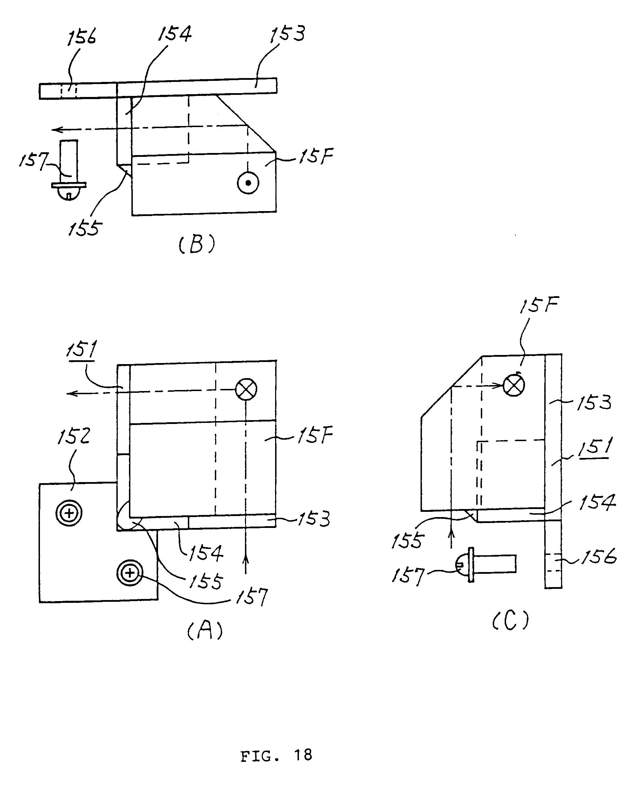

Fig. 16 is a plan view of the optical current transducer of an eighth embodiment according to this invention, and Fig. 17 is a side view which is viewed along an arrow A of Fig. 16. The same elements as in the figures described above are represented by the same reference numerals, and those elements which have the same functions as in the figures described above are represented by the same numerals with an affix letter F. Their description is omitted. In these figures, three optical-path changing pieces 15F, 16F and 17F are fixed to a substrate 23F through fixing pieces 151, 161, 171. The optical-path changing pieces 15F, 16F, 17F are similar to the optical-path changing pieces 15A, 16A, 17A, however, it is a main different point that these optical-path changing pieces are not provided with bolt holes through which bolts 31 are penetrated. As described later, the optical-path changing pieces 15F, 16F, 17F are adhesively attached to the fixing pieces 151, 161, 171 with brazing and the fixing pieces 151, 161, 171 are fixed to the flat surface portion 230 of the substrate 23F with bolts. Accordingly, no adhesive agent is required to temporarily secure the optical-path changing pieces 15F, 16F, 17F. Further, even when the optical axis is deviated after the fabrication, re-adjustment can be performed by loosening the bolts.

The same fixing manner as shown in Fig. 7 is used for the fixing of four Faraday effect glass elements 11F, 12F, 13F, 14F, and thus the description thereof is omitted. Further, frames 231F, 232F, 233F, 234F serving as projection portions which are located on the periphery of the substrate 23 are substantially identical to the frames 231, 232, 233, 234 of Fig. 7. The frames 231F, 232F, 233F, 234F are illustrated as being thicker than those of Fig. 7, however, this difference is insignificant. The bolting shown in Fig. 7 may be used for clamping of the substrates 23F and 24F. Further, the substrate 24F and the frames 231F, 232F, 233F, 234F may be fixed to each other through bolts.

Fig. 18 are diagrams showing only the optical-path changing piece 15F and the fixing piece 151, where Fig. 18(A) is a plan view, Fig. 18(B) is a side view of Fig. 18(A) which is viewed from the upper side and Fig. 18(C) is a side view of Fig. 18(A) which is viewed from the right side. The fixing pieces 161, 171 (Fig. 16) are designed to be identical or symmetrical to the fixing piece 151, and thus only the fixing piece 151 will be described. In this figure, the fixing piece 151 comprises a fixing portion 152 which is provided with a bolt hole 156 and fixed to the surface portion 230 of the substrate 23F with a bolt 157, a flat surface portion 153 which is formed of the same material as the fixing portion and on which the optical-path changing piece 15F is mounted, and an L-shaped portion 154 which abuts against one corner portion of the optical-path changing piece 15F to define the position of the optical-path changing piece 15F. The fixing piece 151 is formed of ceramic, and such construction is performed by mechanical working and an adhesion such as a welding. The optical-path changing piece 15F is fixed to the L-shaped portion 154 through a weld portion 155. A welding method similar to a brazing method in which the same material as the fixing piece 151 is melt may be used for the weld portion 155. This is because only the optical-path changing piece 15F and the fixing piece 151 are treated at the welding time and thus it is not required to pay attention to a thermal effect on the other members at the welding time.

In the figure, the weld portion 155 is located at only one position for the following reason. That is, since the L-shaped portion 154 and the flat surface portion 153 are closely attached to the corner portion of the optical-path changing piece 15F, the optical-path changing piece 15F is not rotated, and thus no large stress occurs in the weld portion 155.

The construction of the fixing piece 151 is not limited to the above shape. For example, the L-shaped portion 154 may be omitted, and the weld portion between the flat surface portion 153 and the optical-path changing piece 15F may be provided at two or three positions. Accordingly, the L-shaped portion has an effect that the weld portion 155 may be provided at only one position. The shape of the fixing portion 152 is not required to be designed in a square which is partially overlapped with the flat surface portion 153 as shown in the figure, and as is apparent from Fig. 16, it may be designed in any suitable shape as long as it does not obstruct the glass elements 11F, 12F at both sides. The two bolts 157 are provided for the following reason. That is, when a unified body of the optical-path changing piece 15F and the fixing piece 151 is rotationally shifted after having been secured to the substrate 23, the body can be prevented from being damaged due to concentration of the stress by the bolts. If there is no possibility of the concentration of the stress, only one bolt may be used.

As is apparent from Fig. 17, there is a gap between the optical-path changing piece 15F and the substrate 24F, so that the optical-path changing piece 15F is not fastened by the substrate 24F.

As described above, the optical-path changing piece 15F is fixed through the fixing piece 151, so that it is not required to provide the bolt holes as shown in Fig. 1 or to fasten the optical-path changing piece by the substrates 23, 24. Accordingly, it is not required for the optical-path changing piece 15F to serve as a spacer for defining the interval between the two substrates 23F, 24F. Therefore, one substrate is provided with the frames 231F, 232F, 233F, 234F having the same function as a spacer like that of Fig. 7. However, the construction is not limited to the above substrate construction. That is, spacers are provided at such four positions that they do not obstruct the other members, and both substrates are fastened by bolts which are penetrated through bolt holes provided at suitable positions in the substrates. Actually, in order to prevent attachment of dust or water droplets to the glass elements and the optical-path changing pieces, a space in which these elements are mounted is sealed. The frames 231F, 232F, 233F, 234F and the substrates 23F, 24F serve as parts of a sealing chamber, the construction as shown in the figure is the best practical one. In Fig. 16, the frames are cut out at the inlet and outlet for the input light a and the output light h. However, the input light a and the output light h are transmitted from or to external equipments through optical fibers, and thus actually the space inside the frames 231F, 232F, 233F and 234F is tightly closed by designing an optical fiber securing portion in a sealing structure.

As described above, according to this invention, the glass elements and the optical-path changing pieces are fixed while sandwiched between the two substrates, and each optical-path changing piece is formed of an integral element, so that adhesion using an adhesive agent is not required to manufacture these elements. Therefore, there occurs no thermal stress due to the difference in coefficient of thermal expansion between the glass elements and the adhesive agent, and thus there occurs no trouble to be caused by the thermal stress. Accordingly, a factor for increasing a measurement error is eliminated, and thus an optical current transducer having high precision is obtained. In this case, the optical-path changing pieces are also used as spacers for defining the interval between the two substrates, the glass elements are inserted into the grooves provided in the substrates, and the dimension of the grooves is set to be larger than that of the glass elements, whereby the glass elements are surely engagedly inserted into the grooves, and a gap occurs partially to prevent application of a clamp force to the glass elements, so that no stress occurs in the glass elements. In addition, even if the glass elements are shifted within the gap interval, when light incident from one end surface of the glass element is emitted from the other end surface thereof, only the light emission position is varied, but the direction of the light is not varied. Therefore, the optical path is not much deviated, and thus the precision of the optical current transducer suffers no effect, and thus it keeps high precision.

When the optical-path changing piece is formed of an integral transparent material as described above, the optical-path changing piece is fixed to one substrate through the fixing piece which is fixed to the substrate by bolting, so that the other substrate is made irrelevant to the fixing of the optical-path changing piece. Therefore, the clamping and fixing method and the construction of the two substrates may be selected irrespective of the optical-path changing piece. Further, the fabrication of the optical-path changing pieces and the fixing pieces can be performed at a stage where they are parts, and the fabrication can be easily performed. In addition, the fixing of the optical-path changing pieces to one substrate can be performed irrespective of the other members, so that the fixing work can be easily performed even after adjustment of the optical path. Further, by providing the frames to one substrate, the frames serving as spacers, and the fixing of the two substrates can be performed irrespective of the optical-path changing pieces. The fixing piece is constructed by the fixing portion which is fixed to the flat surface portion of the substrate by bolting, the flat surface portion on which the optical-path changing piece is mounted, and the L-shaped portion which is erectly secured to the flat surface portion so as to be closely attached to one corner of the optical-path changing piece, these elements being integrally formed with each other, so that the displacement of the optical-path changing piece in the three directions is restricted by the flat surface portion and the L-shaped portion, and the optical-path changing piece and the fixing piece may be welded together at only one position. The brazing welding using the same material as the fixing piece is suitably used for the above welding, and a small number of welding portions simplifies the welding work, and reduces the thermal effect.

By inserting the elastic members into the gaps between the grooves of the substrates and the glass elements, the displacement of the glass elements is restricted within the gaps, thereby preventing the glass elements from being damaged, and reducing the variation of the optical path due to the displacement of the glass elements. In this case, the glass elements are also softly supported, so that there is no possibility that stress due to the supporting and a thermal stress due to temperature variation occur.

Further, the elastic members are inserted over the wide area on the surfaces of the glass elements which are confronted to the grooves, and volume-variable material is used for the elastic members, whereby the thickness of the elastic members is easily variable in accordance with the gap interval between the glass elements and the substrates and thus the soft support can be performed. Or, the elastic members are formed of rubber or springs which are provided at plural local positions on the surfaces of the glass elements, whereby the glass element can be softly supported.

Still further, the two substrates can be fixed to each other by clamping the substrates at suitable positions with a suitable number of bolt/nut sets. At this time, the optical-path changing pieces take the same role as the spacers as described above, the soft support can be performed without directly clamping the glass elements. Further, the bolt holes are provided to the optical-path changing pieces, and the clamping bolts are penetrated through the bolt holes and then clamped, so that no bend stress is applied to the substrates, and clamping stress is uniformly applied to the optical-path changing pieces. Therefore, the concentration of the stress does not occur, and thus the optical current transducer is mechanically strong.

The frames are provided on one substrate so as to project to the other substrate, the reflection surfaces of the optical-path changing pieces are constructed by the mirror surfaces of the respective two reflection portions fixed to the frames, and the frames are also used as the spacers for defining the interval between the two substrates, so that the optical-path changing substrates are not required to be formed of transparent material such as glass. Therefore, an effect that the optimum material for the optical-path changing pieces and the optimum fixing method of the optical-path changing pieces can be selected.

As a method of fixing the reflection portions to the substrate, the reflection portions may be formed integrally with the substrate on which the reflection portions are fixed, so that no adhesion is required. When the reflection portions are produced separately from the substrates and then adhesively attached to the substrate, the adhesion may be performed using the metal deposition, so that no organic adhesive agent is required. When one or both of the substrate and the reflection portion is formed of non-metal material, the metal is melted on the surface containing a welding portion of the non-metal member to form the weld portion through the metal deposition for the fixing.

As a method of forming the reflection surface of the reflection portion, for the metal reflection portion, the surface which is to be a reflection surface is mirror-polished, whereby the reflection surface having excellent reflectivity can be easily formed. Further, for the non-metal reflection portion, metal is deposited like the weld portion to form a metal film, whereby the reflection surface having excellent reflectivity can be easily formed.

Further, the bolts are penetrated through the bolt holes which are formed in the two substrates, and then clamped with the nuts, whereby the two substrates and the four Faraday effect glass elements can be mechanically unified into one body without adhesive agent.

Further, all the elements are formed of inorganic material without organic material, and thus no element is deteriorated with time lapse, so that the optical current transducer has high reliability.

**Claims**

1. An optical current transducer comprising, on a substrate, four rod-shaped Faraday effect glass elements (11A-14A; 11B-14B; 11F-14F) which are disposed in a substantially rectangular shape so as to surround a through hole (20) adapted to be penetrated by an electric conductor, and three optical-path changing pieces (15A-17A; 15B-17B; 15F-1F; 15C; 15D; 15E), wherein each of the glass elements (11A-14A; 11B-14B; 11F-14F) has its longitudinal direction along a respective one of the four side portions of the rectangular shape, and each of the optical-path changing pieces (15A-17A; 15B-17B; 15F-17F; 15C; 15D; 15E) is disposed at a respective one of three of the four corner portions of the rectangular shape, and has two reflection surfaces (15B1, 15B2, 15C1, 15C2, 16B1, 16B2, 17B1, 17B2; 15D1, 15D2, 15E1, 15E2) which serve to reflect light emitted from one glass element to be incident to an adjacent glass element , **characterized in that** two substrates (21, 22; 23, 24; 23F, 24F) are provided to fix said glass elements (11A-14A; 11B-14B; 11F-14F) and said optical-path changing pieces (15A-17A; 15B-17B; 15F-17F; 15C; 15D; 15E) while sandwiching said glass elements (11A-14A; 11B-14B; 11F-14F) and said optical-path changing pieces (15A-17A; 15B-17B; 15F-17F; 15C; 15D; 15E) therebetween, said four glass elements (11A-14A; 11B-14B; 11F-14F) being disposed in respective grooves (211, 221; 215, 225; 235, 245) formed in said two substrates (21, 22; 23, 24; 23F, 24F), and said grooves of said substrates (21, 22; 23, 24; 23F, 24F) are designed to be larger in dimension by a predetermined degree than portions of said glass elements (11A-14A; 11B-14B; 11F-14F) to be inserted into said grooves.

2. The transducer as claimed in claim 1, wherein said optical-path changing pieces (15A-17A) are respectively formed of one integral transparent element, the two reflection surfaces for performing total reflection in said element being formed by cutting said element, and said optical-path changing pieces (15A-17A) serve as spacers for defining the interval between said two substrates (21, 22).

3. The transducer as claimed in claim 1 or 2, wherein a predetermined number of bolt holes (301) are provided at predetermined positions on said two substrates (21, 22) so as to penetrate through said two substrates (21, 22), bolts (31) of bolt/nut sets for bolting are penetrated through said bolt holes.

4. The transducer as claimed in claim 3, wherein a further bolt hole aligned with a respective bolt hole of said two substrates (21, 22) is provided to each of said optical-path changing pieces (15A-17A), and a bolt of a bolt/nut set for bolting extends through said further bolt hole.

5. The transducer as claimed in claim 1, wherein a frame (231-234) is provided on the peripheral portion of one of said two substrates (23, 24; 23F, 24F) so as to project to the other substrate, and each of said optical-path changing pieces (15B-17B; 15F-17F; 15C; 15D; 15E) is fixed to said frame and comprises two reflection portions having reflection surfaces, said frame serving as a spacer for defining the interval between said two substrates (23, 24; 23F, 24F).

6. The transducer as claimed in claim 5, wherein said reflection portions are formed integrally with said substrates (23, 24; 23F, 24F).

7. The transducer as claimed in claim 5, wherein said reflection portions are manufactured separately from said substrates (23, 24; 23F, 24F), and fixed to said substrates.

8. The transducer as claimed in claim 5, 6 or 7, wherein said reflection portions are formed of non-metallic material, and metal films (62-64) are formed on said reflection surfaces thereof.

9. The transducer as claimed in claim 5, 6 or 7, wherein said reflection portions are formed of metallic material, and said reflection surfaces are mirror-polished.

10. The transducer as claimed in claim 1, wherein said optical-path changing pieces (15F-17F) are respectively formed of one integral transparent element, two reflection surfaces for performing total reflection in said element are formed by cutting said element, and said optical-path changing pieces (15F-17F) are fixed through a fixing piece (151, 161, 171) which is fixed to one substrate (23F) by bolting.

11. The transducer as claimed in claim 10, wherein a frame (231F-233F) is provided on the peripheral portion of one of said two substrates (23, 24; 23F, 24F) so as to project to the other substrate.

12. The transducer as claimed in claim 10 or 11, wherein said fixing piece (151, 161, 171) comprises a fixing portion (152) which is fixed to a flat portion of said substrate (23F) by bolting, a flat portion (153) which is formed integrally with said fixing portion and on which said optical-path changing piece (15F) is mounted, and an L-shaped portion (154) which is formed integrally with said flat portion so as to be disposed erectly and closely contacted with one corner portion of said optical-path chang-

**13.** The transducer as claimed in any one of claims 1 to 10, wherein elastic members (213, 223; 236, 246; 214) are provided between said grooves of said substrates (21, 22; 23, 24; 23F, 24F) and said glass elements (11A-14A; 11B-14B; 11F-14F).

**14.** The transducer as claimed in claim 13, wherein said elastic members (213, 223; 236, 246; 214) comprise volume-variable elastic members which extend over wide areas of the faces of said glass elements (11A-14A; 11B-14B; 11F-14F) which are confronted to said grooves (211, 221; 215, 225; 235, 245).

**15.** The transducer as claimed in claim 14, wherein said volume-variable elastic members (213, 223; 236, 246) are formed of a sponge material.

**16.** The transducer as claimed in claim 13, wherein said elastic members are provided at plural local positions on the surfaces of said glass elements (11A-14A; 11B-14B; 11F-14F).

**17.** The transducer as claimed in claim 16, wherein said elastic members are formed of rubber.

**18.** The transducer as claimed in claim 16, wherein said elastic members (214) comprise a spring.

**Patentansprüche**

**1.** Optischer Stromwandler, umfassend, auf einem Substrat, vier stabförmige Faraday-Effekt-Glaselemente (11A-14A; 11B-14B; 11F-14F), die in im wesentlichen rechteckiger Form ein Durchgangsloch (20) umgehend angeordnet sind, das von einem elektrischen Leiter durchsetzbar ist, und drei den optischen Weg ändernde Stücke (15A-17A; 15B-17B; 15F-17F; 15C; 15D; 15E), wobei die Längsrichtung jedes der Glaselemente (11A-14A; 11B-14B; 11F-14F) längs eines jeweiligen der vier Seitenabschnitte der Rechteckform liegt und jedes der den optischen Weg ändernden Stücke (15A-17A; 15B-17B; 15F-17F; 15C; 15D; 15E) an einem jeweiligen von drei der vier Eckabschnitte der Rechteckform angeordnet ist sowie zwei Reflexionsflächen (15B1, 15B2; 15C1, 15C2, 16B1, 16B2, 17B1, 17B2; 15D1, 15D2; 15E1, 15E2) aufweist, die dazu dienen, von einem Glaselement emittiertes Licht so zu reflektieren, daß es auf ein benachbartes Glaselement auftrifft, **dadurch gekennzeichnet**, daß zwei Substrate (21, 22; 23, 24; 23F, 24F) vorgesehen sind, um die Glaselemente (11A-14A; 11B-14B; 11F-14F) und die den optischen Weg ändernden Stücke (15A-17A; 15B-17B; 15F-17F; 15C; 15D; 15E) zu befestigen, wobei sie die Glaselemente (11A-14A; 11B-14B; 11F-14F) und die den optischen Weg ändernden Stücke (15A-17A; 15B-17B; 15F-17F; 15C; 15D; 15E) zwischen sich halten, wobei die vier Glaselemente (11A-14A; 11B-14B; 11F-14F) in jeweiligen, in den zwei Substraten (21, 22; 23, 24; 23F, 24F) gebildeten Nuten (211, 221; 215, 225; 235, 245) angeordnet sind, und die Nuten der Substrate (21, 22; 23, 24; 23F, 24F) so ausgelegt sind, daß sie eine um ein vorbestimmtes Maß größere Abmessung aufweisen als Abschnitte der Glaselemente (11A-14A; 11B-14B; 11F-14F), welche in die Nuten einzusetzen sind.

**2.** Wandler nach Anspruch 1, bei dem die den optischen Weg ändernden Stücke (15A-17A) jeweils aus einem einstückigen transparenten Element gebildet sind, die zwei Reflexionsflächen zum Ausführen einer Totalreflexion in dem Element durch Schneiden dieses Elements gebildet sind und die den optischen Weg ändernden Stücke (15A-17A) als Abstandshalter zum Definieren des Abstands zwischen den zwei Substraten (21, 22) dienen.

**3.** Wandler nach Anspruch 1 oder 2, bei dem eine vorbestimmte Anzahl an Schraubenlöchern (301) an vorbestimmten Stellen in den zwei Substraten (21, 22) so vorgesehen sind, daß sie die zwei Substrate (21, 22) durchsetzen, und Schrauben (31) von Schrauben/Mutter-Sätzen zum Verschrauben diese Schraubenlöcher durchsetzen.

**4.** Wandler nach Anspruch 3, bei dem ein mit einem entsprechenden Schraubenloch der zwei Substrate (21, 22) ausgerichtetes weiteres Schraubenloch in jedem der den optischen Weg ändernden Stücke (15A-17A) vorgesehen ist, und sich eine Schraube eines Schrauben/Mutter-Satzes zum Verschrauben durch das weitere Schraubenloch erstreckt.

**5.** Wandler nach Anspruch 1, bei dem ein Rahmen (231-234) im Umfangsbereich eines der zwei Substrate (23, 24; 23F, 24F) so vorgesehen ist, daß er zum anderen Substrat hin hervorragt, und jedes der den optischen Weg ändernden Stücke (15B-17B; 15F-17F; 15C; 15D; 15E) an dem Rahmen befestigt ist und zwei Reflexionsabschnitte mit Reflexionsflächen aufweist, wobei der Rahmen als Abstandshalter zum Definieren des Abstands zwischen den zwei Substraten (23, 24; 23F, 24F) dient.

**6.** Wandler nach Anspruch 5, bei dem die Reflexionsabschnitte einstückig mit den Substraten (23, 24; 23F, 24F) gebildet sind.

**7.** Wandler nach Anspruch 5, bei dem die Reflexionsabschnitte getrennt von den Substraten (23, 24; 23F, 24F) hergestellt und an den Substraten befestigt sind.

**8.** Wandler nach Anspruch 5, 6 oder 7, bei dem die Reflexionsabschnitte aus nichtmetallischem Material gebildet sind und Metallfilme (62-64) auf deren Reflexionsflächen gebildet sind.

**9.** Wandler nach Anspruch 5, 6 oder 7, bei dem die Reflexionsabschnitte aus metallischem Material gebildet sind und die Reflexionsflächen spiegelpoliert sind.

**10.** Wandler nach Anspruch 1, bei dem die den optischen Weg ändernden Stücke (15F-17F) jeweils aus einem einstückigen transparenten Element gebildet sind, zwei Reflexionsflächen zum Ausführen einer Totalreflexion in dem Element durch Schneiden des Elements gebildet sind und die den optischen Weg ändernden Stücke (15F-17F) durch ein Befestigungsstück (151, 161, 171) befestigt sind, das durch Verschrauben an einem Substrat (23F) befestigt ist.

**11.** Wandler nach Anspruch 10, bei dem ein Rahmen (231F-233F) im Umfangsabschnitt eines der zwei Substrate (23, 24; 23F, 24F) so vorgesehen ist, daß er zum anderen Substrat hin hervorragt.

**12.** Wandler nach Anspruch 10 oder 11, bei dem das Befestigungsstück (151, 161, 171) einen Befestigungsabschnitt (152), der an einem flachen Abschnitt des Substrats (23F) durch Verschrauben befestigt ist, einen flachen Abschnitt (153), der einstückig mit dem Befestigungsabschnitt gebildet und an dem das den optischen Weg ändernde Stück (15F) befestigt ist, und einen L-förmigen Abschnitt (154) umfaßt, der einstückig mit dem flachen Abschnitt so gebildet ist, daß er aufrecht angeordnet ist und sich in engem Kontakt mit einem Eckabschnitt des den optischen Weg ändernden Stücks befindet.

**13.** Wandler nach einem der Ansprüche 1 bis 10, bei dem elastische Elemente (213, 223; 236, 246; 214) zwischen den Nuten der Substrate (21, 22; 23, 24; 23F, 24F) und den Glaselementen (11A-14A; 11B-14B; 11F-14F) vorgesehen sind.

**14.** Wandler nach Anspruch 13, bei dem die elastischen Elemente (213, 223; 236, 246; 214) volumenveränderliche elastische Elemente umfassen, die sich über breite Bereiche der Flächen der Glaselemente (11A-14A; 11B-14B; 11F-14F) erstrecken, welche den Nuten (211, 221; 215, 225; 235, 245) zugewandt sind.

**15.** Wandler nach Anspruch 14, bei dem die volumenveränderlichen elastischen Elemente (213, 223;

236, 246) aus einem schwamm- oder schaumstoffartigen Material gebildet sind.

**16.** Wandler nach Anspruch 13, bei dem die elastischen Elemente an mehreren lokalen Stellen auf den Flächen der Glaselemente (11A-14A; 11B-14B; 11F-14F) vorgesehen sind.

**17.** Wandler nach Anspruch 16, bei dem die elastischen Elemente aus Gummi gebildet sind.

**18.** Wandler nach Anspruch 16, bei dem die elastischen Elemente (214) eine Feder umfassen.

## Revendications

**1.** Transducteur optique de courant comportant, sur un substrat, quatre éléments (11A-14A ; 11B-14B ; 11F-14F) en verre à effet Faraday en forme de tige qui sont disposés suivant une forme sensiblement rectangulaire de manière à entourer un trou (20) de traversée conçu pour être pénétré par un conducteur électrique, et trois pièces (15A-17A ; 15B-17B ; 15F-17F; 15C ; 15D ; 15E) de modification de trajet optique, dans lequel chacun des éléments (11A-14A; 11B-14B ; 11F-14F) en verre a sa direction longitudinale le long de l'une respective des quatre parties de côtés de la forme rectangulaire, et chacune des pièces (15A-17A ; 15B-17B ; 15F-17F ; 15C ; 15D ; 15E) de modification de trajet optique est disposée à l'une respective de trois des quatre parties de coin de la forme rectangulaire, et comporte deux surfaces (15B1, 15B2; 15C1, 15C2, 16B1, 16B2, 17B1, 17B2 ; 15D1, 15D2 ; 15E1, 15E2) de réflexion qui servent à réfléchir de la lumière émise d'un élément en verre pour être incident sur un élément en verre adjacent,
caractérisé en ce que deux substrats (21, 22 ; 23, 24 ; 23F, 24F) sont prévus pour fixer les éléments (11A-14A ; 11B-14B ; 11F-14F) en verre et les pièces (15A-17A ; 15B-17B ; 15F-17F ; 15C : 15D ; 15E) de modification de trajet optique, les éléments (11A-14A ; 11B-14B ; 11F-14F) en verre et les pièces (15A-17A ; 15B-17B ; 15F-17F ; 15C ; 15D ; 15E) de modification de trajet optique étant intercalés entre les substrats, les quatre éléments (11A-14A ; 11B-14B ; 11F-14F) en verre étant disposés dans des rainures (211, 221 ; 215, 225 ; 235, 245) respectives formées dans les deux substrats (21, 22 ; 23, 24 ; 23F, 24F) et les rainures des substrats (21, 22 ; 23, 24 ; 23F, 24F) sont conçues pour être de dimension plus grande dans une mesure déterminée à l'avance que des parties des éléments (11A-14A ; 11B-14B ; 11F-14F) en verre à insérer dans les rainures.

**2.** Transducteur suivant la revendication 1, dans lequel les pièces (15A-17A ) de modification de trajet optique sont respectivement formées d'un élément transparent d'une pièce, les deux surfaces de réflexion pour effectuer une réflexion totale dans ledit élément étant formées en découpant l'élément, et les pièces (15A-17A ) de modification de trajet optique servent en tant qu'entretoises pour définir l'intervalle entre les deux substrats (21, 22).

3. Transducteur suivant la revendication 1 ou 2, dans lequel un nombre déterminé à l'avance de trous (301) de boulons sont prévus à des positions déterminées à l'avance sur les deux substrats (21, 22) de manière à traverser les deux substrats (21, 22), des boulons (31) d'ensembles boulon/écrou pour boulonner étant introduits dans les trous de boulons.

4. Transducteur suivant la revendication 3, dans lequel un trou de bouton supplémentaire aligné avec un trou de bouton respectif des deux substrats (21, 22) est disposé dans chacune des pièces (15A-17A) de modification de trajet optique et un bouton d'un ensemble boulon/écrou pour boulonner s'étend dans le trou de bouton supplémentaire.

5. Transducteur suivant la revendication 1, dans lequel un cadre (231-234) est disposé sur la partie périphérique de l'un des deux substrats (23, 24 ; 23F, 24F) de manière à faire saillie dans l'autre substrat, et chacune des pièces (15B-17B ; 15F-17F ; 15C ; 15D ; 15E) de modification de trajet optique est fixée au cadre et comporte deux parties de réflexion ayant des surfaces de réflexion, te cadre servant d'entretoise pour définir l'intervalle entre les deux substrats (23, 24 ; 23F, 24F).

6. Transducteur suivant la revendication 5, dans lequel les parties de réflexion sont formées d'une pièce avec les substrats (23, 24 ; 23F, 24F).

7. Transducteur suivant la revendication 5, dans lequel les parties de réflexion sont fabriquées séparément des substrats (23, 24 ; 23F, 24F) et sont fixées aux substrats.

8. Transducteur suivant la revendication 5, 6 ou 7, dans lequel les parties de réflexion sont formées de matériau non métallique, et des films (62-64) métalliques sont formés sur les surfaces de réflexion de ceux-ci.

9. Transducteur suivant la revendication 5, 6 ou 7, dans lequel les parties de réflexion sont formées en matériau métallique, et les surfaces de réflexion subissent un fini spéculaire.

10. Transducteur suivant la revendication 1, dans lequel les pièces (15F-17F) de modification de trajet optique sont formées respectivement d'un élément transparent d'une pièce, deux surfaces de réflexion pour effectuer une réflexion totale dans l'élément sont formées en découpant l'élément, et les pièces (15F-17F) de modification de trajet optique sont fixées par une pièce (151, 161, 171) de fixation qui est fixée à un substrat (23F) par boulonnage.

11. Transducteur suivant la revendication 10, dans lequel un cadre (231F-233F) est disposé sur la partie périphérique de t'un des deux substrats (23, 24 ; 23F, 24F) de manière à faire saillie dans l'autre substrat.

12. Transducteur suivant la revendication 10 ou 11, dans lequel la pièce (151, 161, 171) de fixation comporte une partie (152) de fixation qui est fixée à une partie plate du substrat (23F) par boulonnage, une partie (153) plate qui est formée d'une pièce avec la partie de fixation et sur laquelle la pièce (15F) de modification de trajet optique est montée, et une partie (154) en forme de L qui est formée d'une pièce avec la partie plate de manière à être disposée érigée sur une partie de coin de la pièce de modification de trajet optique, en contact serré.

13. Transducteur suivant l'une quelconque des revendications 1 à 10, dans lequel des éléments (213, 223 ; 236, 246 ; 214) élastiques sont disposés entre les rainures des substrats (21, 22 ; 23, 24 ; 23F, 24F) et les éléments (11A-14A ; 11B-14B ; 11F-14F) en verre.

14. Transducteur suivant la revendication 13, dans lequel les éléments (213, 223 ; 236, 246 ; 214) élastiques comportent des éléments élastiques de volume variable qui s'étendent sur des régions larges des faces des éléments (11A-14A ; 11B-14B ; 11F-14F) en verre qui sont en face des rainures (211, 221 ; 215, 225 ; 235, 245).

15. Transducteur suivant la revendication 14, dans lequel les éléments (213, 223 ; 236, 246) élastiques à volume variable sont formés d'un matériau en éponge.

16. Transducteur suivant la revendication 13, dans lequel les éléments élastiques sont disposés en plusieurs positions de localisation sur les surfaces des éléments (11A-14A ; 11B-14B ; 11F-14F) en verre.

17. Transducteur suivant ta revendication 16, dans lequel les éléments élastiques sont formés de caoutchouc.

18. Transducteur suivant la revendication 16, dans lequel les éléments (214) étastiques comportent un ressort.

FIG. 1

FIG. 2

FIG. 3

FIG. 4

213

215

11A

21

225

223

22

FIG. 5

214

11A

21

22

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19